(19) **Europäisches Patentamt European Patent Office Office européen des brevets**

(11) **EP 4 053 635 B1**

(12) **FASCICULE DE BREVET EUROPEEN**

(45) Date de publication et mention de la délivrance du brevet:
**25.06.2025 Bulletin 2025/26**

(21) Numéro de dépôt: **22159798.2**

(22) Date de dépôt: **02.03.2022**

(51) Classification Internationale des Brevets (IPC):
**G03F 7/20** *(2006.01)* **G03F 9/00** *(2006.01)*

(52) Classification Coopérative des Brevets (CPC):
**G03F 7/70791; G03F 7/70275; G03F 7/70383; G03F 7/70466; G03F 7/70475; G03F 9/7003; G03F 9/7007**

(54) **PRÉPARATION D'IMAGE POUR MACHINE D'INSOLATION DE BANDE ET MACHINE D'INSOLATION DE BANDE**

BILDVORBEREITUNG FÜR BANDBELICHTUNGSMASCHINE UND BANDBELICHTUNGSMASCHINE

PREPARATION OF IMAGE FOR STRIP EXPOSURE MACHINE AND STRIP EXPOSURE MACHINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.03.2021 FR 2102121**

(43) Date de publication de la demande:
**07.09.2022 Bulletin 2022/36**

(73) Titulaire: **Altix**
**27100 Val de Reuil (FR)**

(72) Inventeurs:
• **LEBOUCHER, Arnaud**
**76520 BOOS (FR)**
• **MATHIEU, François-Xavier**
**27210 BEUZEVILLE (FR)**
• **LEBRET, David**
**76320 CAUDEBEC LES ELBEUF (FR)**
• **GUILBERT, Alexis**
**27460 IGOVILLE (FR)**

(74) Mandataire: **Cabinet Beau de Loménie**
**103, rue de Grenelle**
**75340 Paris Cedex 07 (FR)**

(56) Documents cités:
**WO-A1-2011/096428       JP-A- 2000 227 661**
**US-A1- 2006 132 735     US-A1- 2008 094 465**
**US-B1- 6 305 856**

## Description

Domaine Technique

Le présent exposé concerne un procédé de préparation d'image pour une machine d'insolation de bande défilante, ainsi qu'une machine d'insolation de ce type.

Le domaine d'application de cette invention est principalement celui des circuits imprimés mais l'invention peut également être utilisée dans tous les domaines utilisant des procédés de transfert d'image tel celui des écrans LCD, des écrans tactiles, des cellules photovoltaïques ou encore celui de la fabrication de pièces de micromécanique par découpe chimique.

Technique antérieure

Historiquement, les machines d'insolation et de transfert d'image utilisaient des clichés photographiques négatifs, montés devant une source lumineuse, afin de projeter une image positive sur un panneau rigide. Ces machines restent encore à jour très efficaces pour produire des panneaux insolés à la chaîne, tous identiques. Toutefois, en raison de l'utilisation d'un cliché physique, ces machines ne permettaient pas de changer rapidement l'image à insoler entre deux séries de fabrication. De plus, ces machines ne permettaient pas non plus de traiter l'image à tracer en lui appliquant des facteurs de mise à l'échelle pour l'adapter à la forme et la taille réelle de chaque panneau traité.

La technique dite de « direct imaging », c'est-à-dire par imagerie directe, a alors été développée afin de se passer de cliché physique, l'image à transférer étant directement projetée à partir d'un cliché numérique à l'aide, par exemple, d'une tête d'insolation munie d'une matrice de micro-miroirs commandables capable de projeter une image composée de pixels en laissant passer, ou non, la lumière d'une source lumineuse pour chaque pixel du cliché numérique. Cette technique facilite grandement la production, et surtout les changements de séries, car le cliché peut facilement être reprogrammé par changement de fichier sans nécessiter de manipulation de la machine d'insolation elle-même.

Par ailleurs, de nouveaux modèles de machines d'insolation ont été développés afin de pouvoir insoler, non plus des panneaux rigides, mais des bandes souples défilantes. Dans de telles machines, un dispositif d'entraînement fait défiler une bande d'un pas au moins égal à la longueur de l'image projetée entre chaque phase de projection. Il est ainsi possible d'insoler plusieurs exemplaires de l'image souhaitée, les uns à la suite des autres, sur une même bande, sans qu'il soit nécessaire de manipuler une pluralité de panneaux en entrée et en sortie de la machine. De plus, de telles machines permettent désormais de fabriquer des circuits imprimés sur des supports souples, ce qui ouvre un nouveau champ d'applications.

Toutefois, quel que soit le type de machine utilisé à ce jour, une contrainte importante subsiste sur la taille de l'image qu'il est possible d'insoler et donc sur la taille du circuit imprimé qu'il est possible d'obtenir de cette manière. En effet, cette taille d'image est limitée par la taille de la zone d'insolation, et donc par la taille de la machine elle-même.

Or, de nouvelles applications nécessitent de circuits de grande taille, possédant une longueur supérieure au mètre, voire même atteignant une dizaine de mètres. Par exemple, dans le domaine aéronautique, il est souhaité de pouvoir réaliser le câblage des cabines à l'aide de tels circuits imprimés souples. Un autre exemple concerne le domaine automobile dans lequel il est souhaité de pouvoir connecter plusieurs batteries réparties en plusieurs endroits dans le plancher du véhicule. On connait par ailleurs les documents US 2008/094465, US 2006/132735, WO 2011/096428 et JP 2000/227661 qui décrivent différentes machines d'insolation de l'état de la technique.

Il existe donc un réel besoin pour une machine d'insolation qui soit dépourvue, au moins en partie, des inconvénients inhérents aux configurations connues précitées.

Exposé de l'invention

La présente invention concerne un procédé de préparation d'image selon la revendication 1.

Ainsi, grâce à un tel procédé de préparation d'image, il est possible, avec une machine d'insolation de bande défilante, d'insoler une pluralité d'images côte à côte en les raboutant de manière à former, de manière continue, soit une image de longueur plus importante, soit une succession de motifs identiques avec une régularité très précise. On parle ainsi de raboutage d'image, ou de « stiching » en langue anglaise.

En particulier, grâce à la zone de recouvrement ainsi prévue, on réduit fortement le risque qu'un léger écart, même de taille très faible, n'apparaisse entre l'image n et l'image n+1, en raison par exemple d'un défaut de positionnement de la bande et/ou du dispositif d'insolation. On assure ainsi une bonne continuité entre l'image n et l'image n+1, ce qui est tout particulièrement important dans le cas d'un circuit imprimé puisqu'il est impératif que la piste électrique ne soit pas interrompue au risque de ne pas pouvoir conduire le courant comme prévu.

A contrario, les inventeurs ont déterminé que le fait que la zone de recouvrement soit insolée deux fois, une première fois lors de la projection de l'image n et une deuxième fois lors de la projection de l'image n+1, n'entraînait pas de défaut, ou en tout cas pas de défaut majeur, dans le produit final.

Dès lors, grâce à un tel procédé, il est possible d'obtenir des images insolées de grande taille sans augmenter la taille de la zone d'insolation et donc sans augmenter particulièrement la taille de la machine d'insolation. Il est alors possible de fabriquer des circuits imprimés dont la longueur dépasse le mètre par exemple.

Dans certains modes de réalisation, la succession d'images comprend des images différentes. Ceci est notamment le cas lorsque l'on souhaite reconstituer une image de longueur supérieure.

Dans certains modes de réalisation, la succession d'images comprend des images toutes identiques. Ceci est notamment le cas lorsque l'on souhaite reproduire un même motif de manière régulière sur la bande.

Dans certains modes de réalisation, le procédé comprend une étape de découpage d'une image numérique primaire en une pluralité d'images numériques secondaires de longueur plus faible, cette pluralité d'images numériques secondaires formant ladite succession d'images. Ceci permet de projeter, par morceau, et ainsi de reconstituer sur la bande, l'ensemble de l'image primaire en tenant compte de la taille maximale de la zone d'insolation.

Dans certains modes de réalisation, un tronçon d'image issu du bord amont de l'image n est ajouté à l'image n+1, au-delà de son bord aval originel, ou un tronçon d'image issu du bord aval de l'image n+1 est ajouté à l'image n, au-delà de son bord amont originel. Ce tronçon d'image ajouté peut ainsi constituer tout ou partie de la zone de recouvrement, sans altérer le contenu propre de l'image n+1, de l'image n respectivement. De plus, de cette manière, la zone de recouvrement reçoit sensiblement deux fois le même tronçon d'image, ce qui évite une éventuelle superposition incohérente de deux tronçons d'image différents.

Dans certains modes de réalisation, la longueur du tronçon d'image ajouté à l'image n+1 est comprise entre 10 et 200 $\mu$m, de préférence entre 50 et 150 $\mu$m, de préférence encore entre 80 et 100 $\mu$m. De préférence cette longueur correspond sensiblement à la longueur de la zone de recouvrement.

Dans certains modes de réalisation, la zone de recouvrement est formée en faisant défiler la bande, après la projection de l'image n, d'une distance strictement inférieure à la longueur de l'image n. Dans un tel cas, il n'est pas utile de rallonger artificiellement l'image n+1.

Dans certains modes de réalisation, l'image n et l'image n+1 ne comprennent, dans la zone de recouvrement, que des lignes rectilignes. De préférence, ces lignes sont orientées dans la direction de défilement ou forment un angle inférieur ou égal à 45° avec cette dernière.

Dans certains modes de réalisation, la zone de recouvrement possède, en moyenne sur la largeur de l'interface entre l'image n+1 et l'image n, une longueur comprise entre 10 et 200 $\mu$m, de préférence entre 50 et 150 $\mu$m, de préférence encore entre 80 et 100 $\mu$m. Une telle plage permet d'assurer une bonne continuité entre les images sans imposer d'importantes contraintes de dessin sur ces dernières.

Dans certains modes de réalisation, la zone de recouvrement possède une longueur au moins égale à 5 $\mu$m, de préférence au moins égale à 10 $\mu$m, en tout point de l'interface entre l'image n+1 et l'image n. On assure ainsi une continuité en tout point de l'interface.

Au-delà de la mise en place d'une zone de recouvrement, les inventeurs ont déterminé qu'il était nécessaire de mettre en place des solutions de suivi de bande lors du positionnement des images les unes par rapport aux autres dès lors qu'il était souhaité de connecter de la sorte un nombre significatif d'images successives. En effet, les inventeurs ont constaté que les bandes présentent fréquemment de petits défauts de rectitude : ainsi, typiquement, une bande à insoler peut présenter un sabre, c'est-à-dire une déviation dans la direction transverse à sa direction d'extension, correspondant à la direction de défilement, pouvant atteindre 100 $\mu$m/m. Une telle déviation peut tout à faire être ignorée lorsque les images sont insolées de manière indépendante les unes des autres ; en revanche, si elle n'est pas prise en considération, elle peut très bien conduire à des sorties de bande lorsque plusieurs images sont projetées dans la continuité les unes des autres. D'autres déformations de la bande, dont certaines peuvent être causées par une tension asymétrique de la bande lors de son entraînement, peuvent également causer des difficultés de suivi de bande.

Les inventeurs ont alors imaginé plusieurs solutions permettant d'assurer ce suivi de bande. Ces solutions sont présentées ci-après.

Dans certains modes de réalisation, la première image est positionnée sans déformation en se basant sur quatre mires de la bande. En particulier, la première image peut être positionnée en positionnant son barycentre sur le barycentre des quatre mires. Son orientation peut ensuite être fixée en minimisant l'écart moyen entre la position réelle de chaque mire et la position du point de calage correspondant de l'image. Les points de calage de l'image sont les points de l'image qui sont supposés coïncider avec les mires théoriques de la bande, c'est-à-dire les mires dans un état parfait de la bande, sans aucune déformation de la bande et sans aucune erreur de positionnement des mires sur la bande lors de la préparation de cette dernière.

Dans certains modes de réalisation, la première image est positionnée, avec éventuelle déformation, de manière à faire coïncider quatre points de calage prédéterminés de l'image avec quatre mires de la bande.

Dans certains exemples pas couverts par l'invention, les mires sont des marques réelles prévues sur la bande. Il peut notamment s'agir de trous pratiqués dans la bande. Toutefois, les bords de bande peuvent également être détectés par un ou plusieurs dispositifs de vision.

Dans certains exemples pas couverts par l'invention, les mires sont des mires virtuelles issues de la détection des bords de bande. Ces bords de bande peuvent notamment être détectés par un ou plusieurs dispositifs de vision.

Selon l'invention, des mires sont ajoutées à l'image n à proximité de ses deux angles amont. A cet égard, on considère qu'une mire est à proximité d'un élément de l'image si la distance la séparant de cet élément de l'image est inférieure à 10%, et de préférence inférieure à 5%, de la longueur de l'image. Ces mires additionnelles facilitent le positionnement de l'image n+1 et permettent en outre de compenser une éventuelle erreur de centrage du dispositif de projection.

Dans certains modes de réalisation, au moins deux mires sont ajoutées à l'image n à distance du bord amont de l'image n. A cet égard, on considère qu'une mire est à distance d'un élément de l'image si la distance la séparant de cet élément de l'image est supérieure à 10% de la longueur de l'image. Ces mires sont utiles lorsqu'une insolation recto-verso est prévue pour la bande en question afin de faciliter l'alignement de l'image verso par rapport à l'image recto déjà insolée. De préférence, au moins l'une de ces mires est prévue dans la moitié aval de l'image n. De préférence, ces deux mires sont prévues à proximité d'un bord latéral de l'image n.

Dans certains modes de réalisation, l'image n+1 est positionnée sans déformation en se basant sur au moins deux mires de la bande. Certaines applications privilégient une reproduction sans déformation de l'image, quitte à réduire la taille de la zone de recouvrement selon l'importance de la déformation de la bande.

Dans certains modes de réalisation, l'image n+1 est positionnée sans déformation en se basant uniquement sur deux mires réelles insolées avec l'image n. Dans un tel cas, les coordonnées des points de calage amont de l'image n+1 peuvent être calculées de manière théorique à partir des coordonnées des points de calage aval positionnés à l'aide des deux mires réelles de l'image n. Cette solution assure une bonne cohérence de la zone de recouvrement et permet d'éviter de déformer l'image n+1. Elle ne permet pas en revanche de suivre la bande : il peut donc être utile de prévoir des marges latérales plus importantes ou de sélectionner une bande de meilleure qualité présentant des déformations plus faibles.

Dans certains modes de réalisation, l'image n+1 est positionnée sans déformation en positionnant son barycentre sur le barycentre de quatre mires. Son orientation peut ensuite être fixée en minimisant l'écart moyen entre la position réelle de chaque mire et la position du point de calage correspondant de l'image. Cette solution permet de suivre la bande sans déformer l'image. Toutefois, elle peut réduire la taille de la zone de recouvrement de manière significative si la bande présente un sabre important.

Dans certains modes de réalisation, l'image n+1 est positionnée, avec éventuelle déformation, de manière à faire coïncider quatre points de calage prédéterminés de l'image avec quatre mires de la bande. Certaines applications ne nécessitent pas une reproduction fidèle de l'image dès lors que la topologie de l'image est respectée : ceci est notamment le cas des applications circuits imprimés. Un tel positionnement avec déformation éventuelle permet d'assurer un bon recouvrement tout le long de l'interface de la zone de recouvrement.

Dans certains modes de réalisation, l'image n+1 est positionnée en se basant sur quatre marques réelles de la bande, ces marques pouvant par exemple être des trous. Un tel positionnement est particulièrement facile à mettre en œuvre et permet un suivi de bande automatique. Il peut toutefois conduire à des déformations significatives de l'image et, éventuellement, à des défauts de cohérence de la zone de recouvrement si le dispositif de projection est mal centré. En revanche, une telle méthode assure un très bon alignement des images recto et verso et se trouve donc particulièrement adaptée pour les applications double-face.

Dans certains modes de réalisation, l'image n+1 est positionnée en se basant sur deux mires réelles insolées avec l'image n et deux marques réelles de la bande, ces marques pouvant par exemple être des trous. Un tel positionnement est également facile à mettre en œuvre et assure en outre une bonne cohérence de la zone de recouvrement. Le suivi de bande est également assuré.

Dans certains modes de réalisation, l'image n+1 est positionnée en se basant sur deux mires réelles insolées avec l'image n et deux mires virtuelles issues de la détection des bords de bande. Une telle solution vise à imiter la solution de positionnement ci-dessus en l'absence de marque réelle sur la bande.

Dans certains modes de réalisation, l'image n+1 est positionnée en se basant sur deux mires réelles insolées avec l'image n et deux mires virtuelles issues de la détection de marques réelles de la bande, ces marques pouvant par exemple être des trous. Cette solution a pour objectif de corriger la position des marques réelles lorsque ces dernières dévient de manière trop importante de leurs positions théorique. En particulier, les deux mires virtuelles ainsi considérées peuvent partager le même barycentre que les marques réelles correspondantes avec la contrainte, d'une part, d'être alignées dans la direction transverse à la direction de défilement et, d'autre part, d'être espacées d'une distance prédéterminée. De cette manière, on assure que les bords amont et aval de toutes les images, à l'exception éventuellement des deux premières, sont tous parallèles, ce qui assure une bonne cohérence de la zone de recouvrement. De plus, le suivi de bande peut se faire en limitant la déformation subie par l'image n+1 à une déformation de cisaillement unidirectionnel. En revanche, une telle méthode peut engendrer un décalage entre le positionnement de l'image recto et celui de l'image verso de telle sorte que ce mode de réalisation est réservé de préférence aux applications simple face.

Dans certains modes de réalisation, la méthode de positionnement utilisée varie en fonction de l'image. Cette variation peut être prédéterminée, selon une alternance particulière par exemple, ou bien déterminée en cours de fonctionnement en fonction de certains paramètres de l'insolation, liés par exemple à l'image ou à la bande. En particulier, la déformation locale de la bande peut être mesurée avant la projection de chaque image et la méthode de positionnement de l'image considérée peut être sélectionnée en fonction de cette mesure.

Dans certains modes de réalisation, au moins deux positions sont calculées pour l'image n+1 avec des méthodes différentes et l'une de ces positions, ou une position hybride calculée à partir des positions, est retenue en fonction d'un arbitrage prédéterminée. Par exemple, deux positions limites peuvent être calculées à l'aide de deux méthodes différentes et soumises à des coefficients de pondération pour aboutir à une position hybride. En fonction de l'application souhaitée, Il est ainsi possible de choisir un bon compromis entre une bonne cohérence de la zone de recouvrement, un bon suivi de la bande et/ou une faible déformation de l'image. En particulier, plusieurs arbitrages peuvent être préprogrammés dans la machine d'insolation et sélectionnés en fonction des spécificités de l'application en question.

Le présent exposé concerne également une machine d'insolation de bande défilante, comprenant un support, comportant une zone d'insolation, un disposition d'insolation, prévu en vis-à-vis de la zone d'insolation du support, comprenant au moins une source lumineuse et au moins un dispositif de projection configuré pour projeter une succession d'images dans la zone d'insolation à partir d'un ou plusieurs fichiers numériques, un dispositif de guidage et d'entraînement de bande, configuré pour tendre une bande sur le support et pour la déplacer selon une direction de défilement passant par la zone d'insolation, et une unité numérique de préparation d'image, configurée pour positionner, orienter, modifier et/ou déformer une image avant sa projection par le dispositif de projection, dans laquelle l'unité numérique de préparation d'image est configurée pour mettre en œuvre un procédé de préparation d'image selon l'un quelconque des modes de réalisation précédents.

Cette machine bénéficie ainsi de tous les avantages exposés ci-avant.

Dans certains modes de réalisation, au moins une source lumineuse du dispositif d'insolation est une source ultra-violette.

Dans certains modes de réalisation, le dispositif de projection comprend au moins une matrice de micro-miroirs commandables. Le dispositif de projection pourrait toutefois mettre en œuvre une autre technique de projection directe, et notamment une source laser UV ou LED UV associée à des miroirs galvanométriques, ou à un miroir polygonal rotatif, et à un dispositif de modulation haute vitesse tel qu'un modulateur acousto-optique par exemple.

Dans certains modes de réalisation, le dispositif de projection comprend au moins une, et de préférence plusieurs, tête d'insolation capable de se déplacer pour balayer, éventuellement collectivement, la totalité de la zone d'insolation. Toutefois, dans d'autres modes de réalisation, le dispositif de projection est capable de projeter une image sur l'ensemble de la zone d'insolation en une seule fois.

Dans certains modes de réalisation, le dispositif de guidage et d'entraînement est configuré pour déplacer la bande dans la direction de défilement entre chaque projection d'image. Comme indiqué plus haut, le pas de ce défilement peut correspondre à la longueur de l'image ou bien être strictement inférieur à ce dernier.

Dans certains modes de réalisation, le dispositif de guidage et d'entraînement est muni d'un dispositif de centrage configuré pour centrer la bande dans la zone d'insolation dans la direction transverse à la direction de défilement. Ceci permet de compenser les éventuelles déformations à grande échelle de la bande.

Dans certains modes de réalisation, la machine d'insolation comprend un dérouleur, en amont du support, configuré pour recevoir un rouleau de bande à insoler et pour dérouler ladite bande et la transmettre au dispositif de guidage et d'entraînement.

Dans certains modes de réalisation, la machine d'insolation comprend un enrouleur, en aval du support, configuré pour recevoir la bande insolée après son franchissement de la zone d'insolation et pour l'enrouler sous la forme d'un rouleau de bande insolée.

Dans certains modes de réalisation, la machine d'insolation comprend un premier dispositif de vision, comprenant au moins une caméra, et de préférence deux ou quatre caméras, prévu face au support, configuré pour identifier et repérer un bord de bande et/ou des mires sur la face recto de la bande. Ces mires peuvent notamment être des mires insolées ou des trous.

Dans certains modes de réalisation, la machine d'insolation comprend un deuxième dispositif de vision, comprenant au moins une caméra, et de préférence trois ou cinq caméras, prévue dans le support, configuré pour identifier et repérer des mires sur la face verso de la bande. Ces marques peuvent notamment être des mires insolées ou des trous.

Dans certains modes de réalisation, la bande possède une largeur comprise entre 150 et 630 mm. En particulier, la machine d'insolation peut recevoir des bandes de tailles variables, la machine d'insolation étant configurée pour ajuster le centrage de ses organes, et notamment de son dispositif de projection et de ses dispositifs de vision, en fonction de la largeur de la bande et de la taille des images.

Dans certains modes de réalisation, chaque image comprend une largeur comprise entre 150 et 630 mm et une longueur comprise entre 15 et 685 mm.

Le présent exposé concerne également un programme d'ordinateur comprenant des instructions pour exécuter les étapes du procédé de préparation d'image de l'un quelconque des modes de réalisation précédents. Naturellement, un tel programme d'ordinateur peut comprendre en pratique une pluralité de sous-programmes coopérant les uns avec les autres.

Dans le présent exposé, les termes « longitudinal », « transversal » et leurs dérivés sont définis par rapport à la direction d'extension et de défilement de la bande ; de plus, les termes « amont » et « aval » sont définis par rapport au défilement de la bande dans la machine d'insolation.

Les caractéristiques et avantages précités, ainsi que d'autres, apparaîtront à la lecture de la description détaillée qui suit, d'exemples de réalisation de la machine et du procédé proposés. Cette description détaillée fait référence aux dessins annexés.

Brève description des dessins

Les dessins annexés sont schématiques et visent avant tout à illustrer les principes de l'exposé.

Sur ces dessins, d'une figure à l'autre, des éléments (ou parties d'élément) identiques sont repérés par les mêmes signes de référence. En outre, des éléments (ou parties d'élément) appartenant à des exemples de réalisation différents mais ayant une fonction analogue sont repérés sur les figures par des références numériques incrémentées de 100, 200, etc.

[Fig. 1] La figure 1 est une vue d'ensemble d'une machine d'insolation.

[Fig. 2] La figure 2 est une vue de dessus de la zone d'insolation de la machine d'insolation.

[Fig. 3] La figure 3 illustre une étape de découpage d'image numérique.

[Fig. 4] La figure 4 illustre une étape de préparation d'image.

[Fig. 5] La figure 5 illustre un premier exemple de bande.

[Fig. 6] La figure 6 illustre le positionnement de la première image dans un premier exemple de procédé.

[Fig. 7] La figure 7 illustre le positionnement de l'image n+1 dans le premier exemple de procédé.

[Fig. 8] La figure 8 illustre le positionnement de la première image dans un deuxième exemple de procédé.

[Fig. 9] La figure 9 illustre le positionnement de l'image n+1 dans le deuxième exemple de procédé.

[Fig. 10] La figure 10 illustre le positionnement de l'image n+1 dans un troisième exemple de procédé.

[Fig. 11A] La figure 11A illustre une première étape de positionnement de l'image n+1 dans un quatrième exemple de procédé.

[Fig. 11B] La figure 11B illustre une deuxième étape de positionnement de l'image n+1 dans le quatrième exemple de procédé.

[Fig. 11C] La figure 11C illustre une troisième étape de positionnement de l'image n+1 dans le quatrième exemple de procédé.

[Fig. 12] La figure 12 illustre le positionnement de la première image dans un cinquième exemple de procédé.

[Fig. 13] La figure 13 illustre la construction de mires virtuelles dans le cinquième exemple de procédé

[Fig. 14] La figure 14 illustre la mise en place de mires réelles dans le cinquième exemple de procédé.

[Fig. 15] La figure 15 illustre le positionnement de l'image n+1 dans le cinquième exemple de procédé.

[Fig. 16] La figure 16 illustre le positionnement de l'image n+1 dans un sixième exemple de procédé.

Description des modes de réalisation

Afin de rendre plus concret l'exposé, des exemples de machines d'insolation et de procédés de préparation d'image sont décrits en détail ci-après, en référence aux dessins annexés. Il est rappelé que l'invention ne se limite pas à ces exemples.

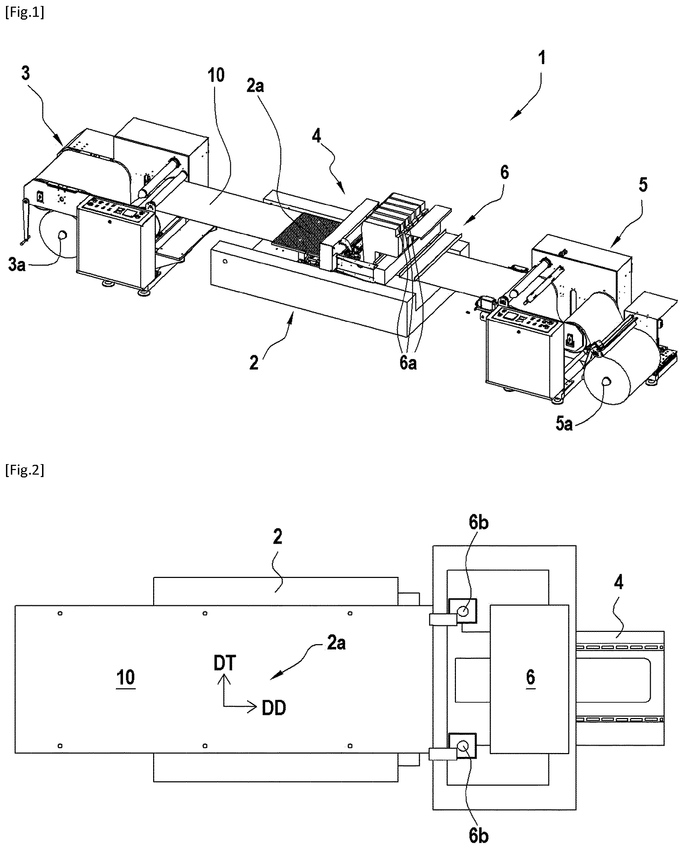

La figure 1 représente une machine d'insolation 1 selon l'exposé. Elle comprend une table d'insolation 2, un dérouleur de bande 3, un dispositif de guidage et d'entraînement de bande 4, un enrouleur de bande 5, un dispositif d'insolation 6 et un dispositif de refroidissement. Certains de ces organes sont également visibles sur la figure 2.

La table d'insolation 2, faisant office de support, possède une surface supérieure plane définissant une zone d'insolation 2a. Dans le présent exemple, la zone d'insolation possède une longueur de 700 mm et une largeur de 650 mm.

Le dérouleur de bande 3 porte un ou plusieurs rouleaux 3a de bande à insoler 10. Il est configuré pour dérouler la bande à insoler 10, recouverte de matériau photosensible, à partir d'un rouleau 3a et transmettre cette dernière au dispositif de guidage et d'entraînement 4.

Le dispositif de guidage et d'entraînement 4 comprend une pluralité de guides et de pinces d'entraînement permettant d'entraîner la bande 10 le long de la table 2 selon une direction de défilement DD. Le dispositif de guidage et d'entraînement 4 contrôle donc quel tronçon de la bande 10 se situe dans la zone d'insolation 2a. Il est notamment équipé d'un dispositif de centrage permettant de régler la position de la bande 10 sur la table 2a dans la direction transverse DT à la direction de défilement DD. En particulier, le dispositif de guidage et d'entraînement 4 est capable de s'adapter à différentes largeurs de bande 10.

L'enrouleur 5 récupère la bande 10 après son passage sur le table 2, et donc après son insolation, et enroule cette dernière sous la forme d'un ou plusieurs rouleaux de bande insolée 5a.

Le dispositif d'insolation 6 est pour sa part prévu en vis-à-vis de la table 2. Il comprend une pluralité de tête d'insolation 6a équipées chacune d'une source lumineuse ultraviolette et d'une matrice de micro-miroirs commandables. Les têtes d'insolation 6a sont mobiles dans la direction de défilement DD et dans la direction transverse DT pour balayer l'ensemble de la zone d'insolation 2a.

Ainsi, le dispositif d'insolation 6 peut recevoir une image dans un format numérique et transférer cette dernière sur la bande 10 par projection de l'image et impression de cette dernière sur la surface photosensible de la bande 10.

Enfin, le dispositif de refroidissement comprend un premier module configuré pour refroidir les têtes d'insolation 6a du dispositif d'insolation 6 et un deuxième module configuré pour maintenir une température constante dans l'enceinte globale de la machine.

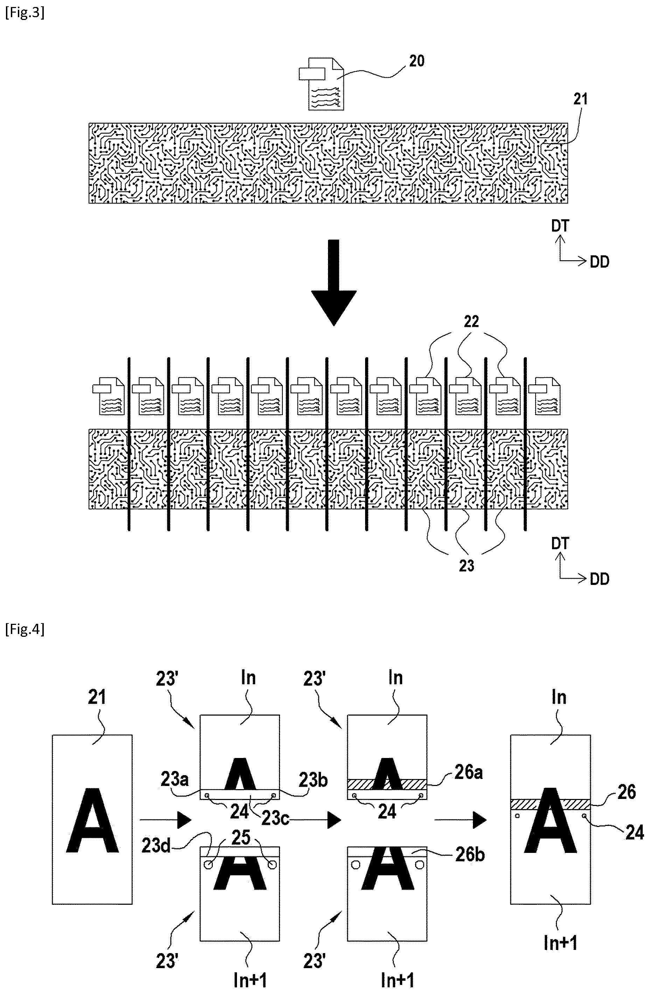

Un procédé de préparation d'image selon l'exposé va maintenant être décrit en référence aux figures 3 et 4. Le point de départ de ce procédé est un fichier image 20. A cet égard, il convient de distinguer la notion d'image fonctionnelle, qui correspond à l'image utile que l'utilisateur chercher à reproduire sur la bande pour obtenir le motif recherché, et la notion d'image technique qui englobe l'image fonctionnelle et prévoit une ou plusieurs marges techniques autour de cette dernière afin de lui ajouter des éléments techniques, par exemple des mires ou une bande de recouvrement. Dans le présent exposé, en l'absence de précision, on entend considérer l'image fonctionnelle.

Si ce fichier primaire 20, contenant l'image fonctionnelle complète à insoler, possède une longueur supérieure à celle de la zone d'insolation 2a, il subit alors une étape de découpage au cours de laquelle l'image fonctionnelle 21 est découpée en une pluralité d'images secondaires 23, fonctionnelles, enregistrées dans autant de fichiers 22, de telle sorte que la longueur de chacune des images secondaires 23 soit inférieure à la longueur de la zone d'insolation 2a.

Dans une étape ultérieure, les images secondaires 23 sont modifiées de manière à prévoir une zone de recouvrement à l'interface entre chaque image fonctionnelle : les images secondaires 23 deviennent ainsi des images techniques 23' comprenant l'image fonctionnelle désirée et des éléments techniques additionnels. Une telle étape est représentée schématiquement sur la figure 4 dans un cas simplifié ne comprenant que deux

images secondaires $I_n$ et $I_{n+1}$. En pratique, cette étape peut être réalisée conjointement à l'étape de découpage décrite ci-dessus.

On note tout d'abord que des mires 24 sont ajoutées à l'image fonctionnelle $I_n$, à proximité de chacun de ses angles amont 23a, 23b. Dans l'exemple représenté, ces mires 24 sont ajoutées au-delà du bord amont 23c de l'image fonctionnelle $I_n$ ; toutefois, elles pourraient également être ajoutées dans le cadre de l'image fonctionnelle $I_n$ lui-même, dans des zones dépourvues de motifs à transférer.

L'image $I_{n+1}$ comporte quant à elle, dans ses métadonnées, l'emplacement de deux points de calage 25, représentés ici schématiquement par des cercles mais n'étant pas destinés à être insolés. Les coordonnées de ces points de calage 25 correspondent aux coordonnées théoriques que devraient avoir les mires 24 dans le référentiel de l'image $I_{n+1}$ une fois les deux images insolées l'une à la suite de l'autre de manière à reformer l'image primaire 21.

Ensuite, une zone de recouvrement 26 est ménagée entre les deux images fonctionnelles $I_n$ et $I_{n+1}$ en ajoutant à l'image fonctionnelle $I_{n+1}$, le long de son bord aval 23d, une bande d'image 26b provenant de la portion 26a la plus amont de l'image $I_n$.

Ainsi, lors de l'insolation, l'image fonctionnelle $I_n$ est tout d'abord insolée avec ses mires 24 ; la bande 10 défile ensuite d'un pas correspondant à la longueur de l'image fonctionnelle $I_n$ ; le dispositif d'insolation 6 utilise alors un dispositif de vision muni de caméras 6b pour repérer les mires 24 et positionner l'image $I_{n+1}$ de manière à faire coïncider les points de calage 25 avec les mires 24 ; enfin, l'image $I_{n+1}$ est insolée avec sa bande additionnelle 26b qui se superpose alors avec la portion aval 26a de l'image $I_n$, formant ainsi une zone de recouvrement 26 insolée deux fois.

Cet exemple est bien entendu simplifié pour faciliter la compréhension du principe général de découpage et de recouvrement des images. En particulier, cet exemple se place dans l'hypothèse où la bande 10 est parfaitement droite, ce qui est rarement le cas en pratique.

Plusieurs exemples de méthodes de positionnement des images les unes par rapport aux autres vont donc être maintenant être décrites.

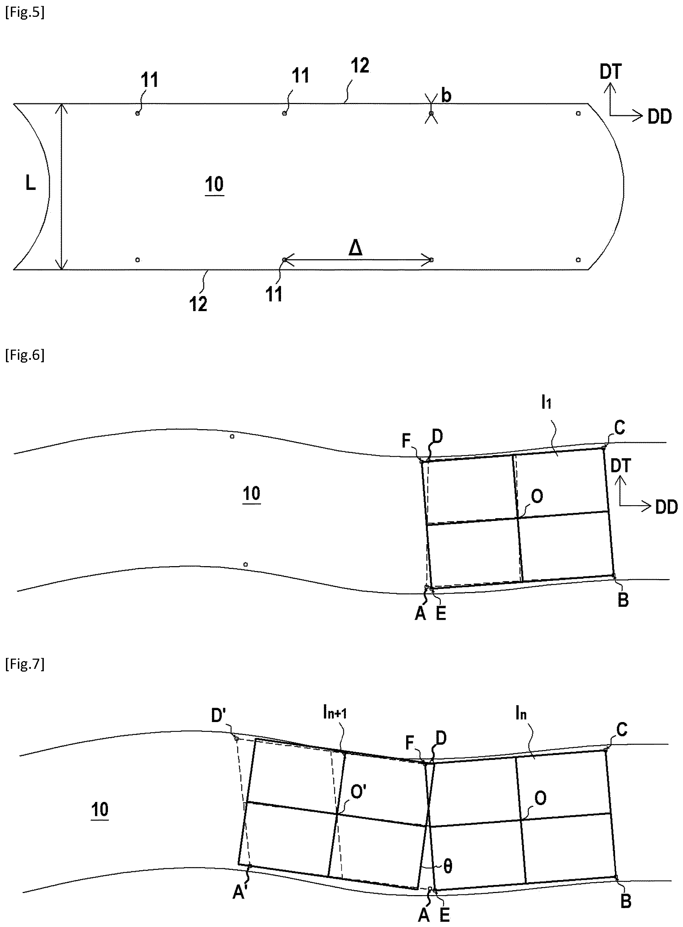

Le premier exemple est décrit en référence aux figures 5, 6 et 7. Dans cet exemple, la bande vierge 10 possède des marques 11 régulièrement espacées le long de ses deux bords longitudinaux 12. De préférence, le pas Δ entre chaque marque 11 est régulier et correspond à la longueur y des images attendues. Typiquement, il peut s'agir de trous pratiqués dans la bande 10 : cela est notamment le cas des bandes 10 destinées à former les couches externes d'un empilement de couches formant un circuit imprimé multi-couches.

Dans le présent exemple, les images possèdent une longueur y de 600 mm et une largeur x de 500 mm. La bande 10 possède alors une largeur L égale à 610 mm ; les trous 11 sont prévus à une distance b du bord 12 de bande 10 égale à 3 mm et son espacés d'un pas Δ égal à 600 mm.

Dans la suite des figures, les déformations de la bande 10 sont volontairement exagérées afin de mieux illustrer le propos. En réalité, les déformations sont inférieures au millimètre. De plus, à fins de simplification, il est considéré dans chacune de ces figures que les points de calage de chaque image correspondent aux quatre coins de l'image considérée ; toutefois, en pratique, ces points de calage peuvent se situer à l'intérieur de l'image fonctionnelle ou au-delà des bords de l'image fonctionnelle tout en restant de préférence à proximité des coins de l'image fonctionnelle.

Dans le premier exemple, la première image I1 est positionnée sans déformation en se basant sur les quatre premiers trous A, B, C, D de la bande 10. L'unité numérique de préparation d'image calcule alors la position du barycentre O du quadrilatère ABCD et positionne l'image I1 de telle sorte que son barycentre soit positionné sur ce barycentre O ; il oriente ensuite l'image I1 autour de ce point O en minimisant la distance moyenne entre les points de calage de l'image I1 et les trous A, B, C, D.

L'image I1 ainsi positionnée peut alors être projetée et insolée sur la bande 10. A cette occasion, des mires E et F sont également insolées au niveau des points de calage théoriques aval de l'image suivante, soit ici dans les coins amont de la première image I1.

La figure 7 illustre alors le positionnement de l'image $I_{n+1}$ par rapport à l'image précédente $I_n$. Dans ce premier exemple, l'image $I_{n+1}$ est positionnée sans déformation en se basant sur les mires E et F de l'image $I_n$ et sur les trous suivants A' et D' de la bande 10. L'unité numérique de préparation d'image calcule alors la position du barycentre O' du quadrilatère A'EFD' et positionne l'image $I_{n+1}$ de telle sorte que son barycentre soit positionné sur ce barycentre O' ; il oriente ensuite l'image $I_{n+1}$ autour de ce point O' en minimisant la distance moyenne entre les points de calage de l'image $I_{n+1}$ et les points A', E, F, D'.

Dans cet exemple, on peut alors noter que l'image $I_{n+1}$ forme un angle θ avec l'image $I_n$. On comprend alors naturellement que, plus le sabre de la bande 10 est important, plus l'angle θ est important et plus la longueur de la zone de recouvrement sera faible à l'une de ses extrémités jusqu'à éventuellement conduire à un écart entre les deux images comme c'est le cas ici dans cet exemple volontairement exagéré.

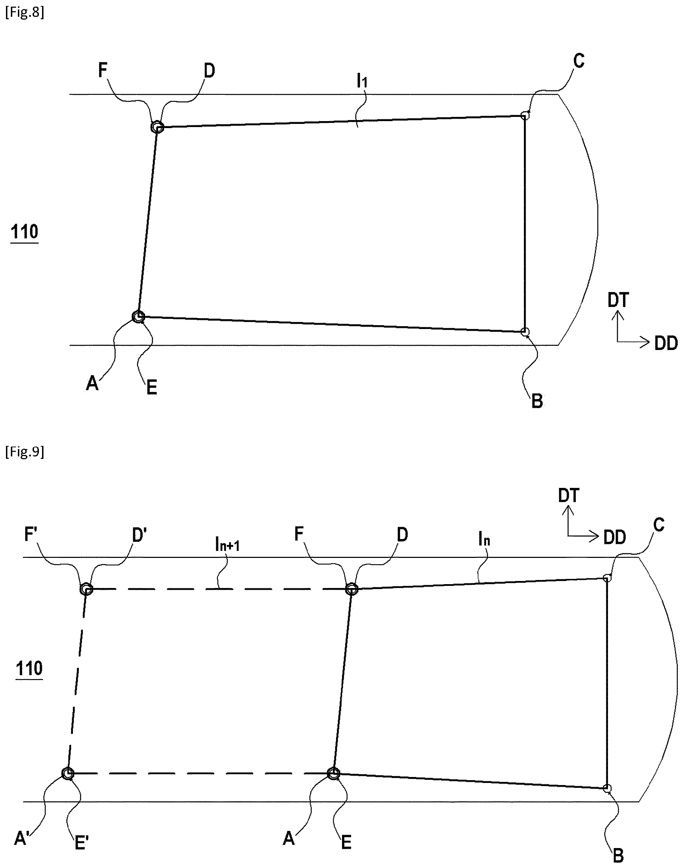

La figure 8 illustre un deuxième exemple de méthode de positionnement dans lequel la bande 110 est identique à celle du premier exemple. En revanche, le positionnement de la première image I1 est différent.

Dans ce deuxième exemple, l'unité numérique de préparation d'image déforme la première image I1 afin de positionner ses quatre points de calage sur les trous A, B, C, D de la bande 110, ce qui aboutit au positionnement de la première image I1. Des mires E et F peuvent également être insolées au niveau des points de calage théoriques aval de l'image suivante, soit ici au niveau des coins amont de la première image I1.

La figure 9 illustre alors le positionnement de l'image $I_{n+1}$ par rapport à l'image précédente $I_n$. Dans ce deuxième exemple, l'unité numérique de préparation d'image déforme l'image $I_{n+1}$ afin de positionner ses quatre points de calage sur les mires E et F de l'image $I_n$ et les trous suivants A', D' de la bande 110. Des mires E' et F' sont également insolées de manière analogue.

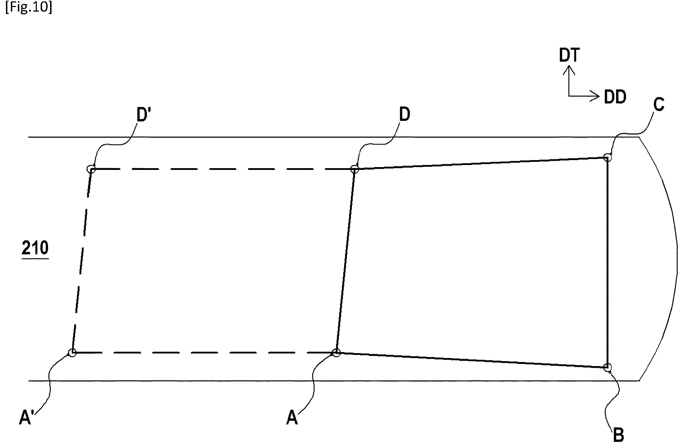

La figure 10 illustre un troisième exemple de méthode de positionnement dans lequel la bande 210 est identique à celle du premier exemple. Le positionnement de la première image I1 est pour sa part identique à celui du deuxième exemple.

Dans ce troisième exemple, aucune mire réelle E, F n'est insolée. L'image $I_{n+1}$ est positionnée, après déformation, en positionnant ses points de calage sur les quatre trous A', A, D, D' de la bande 210.

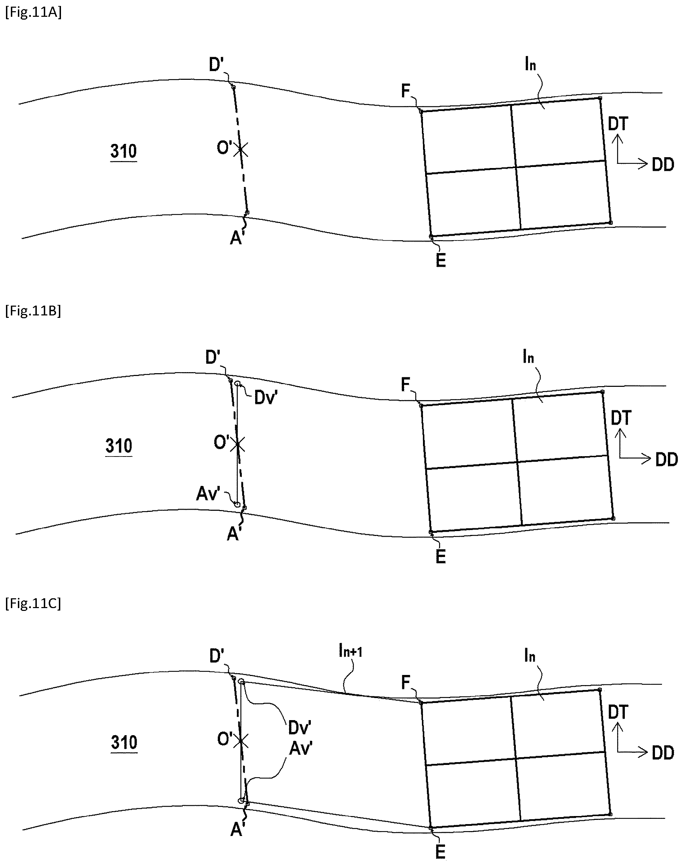

Les figures 11A-11C illustrent un quatrième exemple de méthode de positionnement dans lequel la bande 310 est identique à celle du premier exemple et le positionnement de la première image I1 est identique à celui du deuxième exemple.

Dans ce quatrième exemple, afin de positionner l'image $I_{n+1}$, l'unité numérique de préparation d'image calcule tout d'abord la position du centre O' du segment A'D'. Puis, l'unité numérique de préparation d'image calcule la position de deux mires virtuelles Av' et Dv' en positionnant ces dernières de telle sorte que le segment Av'Dv' s'étende dans la direction transverse DT, possède O' comme centre, et possède une longueur égale à la distance séparant les deux points de calage de l'image $I_{n+1}$. L'image $I_{n+1}$ est alors déformée afin de positionner ses quatre points de calage sur les quatre points Av', E, F, Dv', ce qui aboutit au positionnement de l'image $I_{n+1}$ par rapport à l'image $I_n$.

Ainsi, à partir de la deuxième image, toutes les images successives prennent la forme de parallélogrammes dont les bords aval et amont sont tous parallèles à la direction transverse DT.

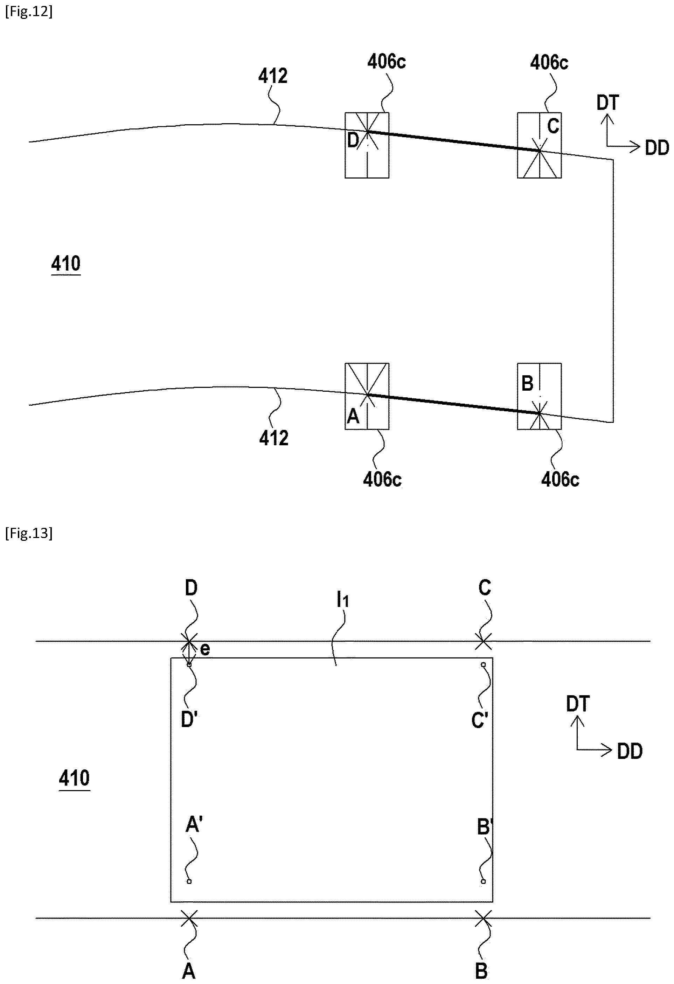

Les figures 12 à 15 illustrent un cinquième exemple de méthode de positionnement. Dans cet exemple, la bande 410 est différente : elle est en effet dépourvue de tout marquage préalable. Cela est notamment le cas des bandes 410 destinées à former les couches internes d'un empilement de couches formant un circuit imprimé multi-couches.

En l'absence de marques sur la bande 410, des mires virtuelles sont calculées par le dispositif de vision. Le dispositif de vision comprend pour cela deux caméras capables de se déplacer et de se positionner à des coordonnées prédéterminées en fonction de la longueur y et de la largeur x des images. Le dispositif de vision est alors capable de détecter le bord 412 de la bande 410 dans le champ 406c de chacune des caméras : il détermine alors les coordonnées des points A, B, C, D situés, pour chaque caméra, à l'intersection du bord de bande 412 et du segment médian du champ 406c de la caméra.

Le dispositif de vision calcule alors les coordonnées de mires virtuelles A', B', C', D' en les positionnement à une distance prédéterminée e, ici égale à 10 mm, à l'intérieur de la bande 410 dans la direction transverse DT.

La première image I1 peut alors être positionnée en se basant sur ces quatre mires virtuelles A', B', C', D' selon l'une des méthodes présentées ci-avant, par exemple selon la méthode sans déformation du premier exemple.

Lors de l'insolation de chaque image $I_n$, deux premières mires, G et J, sont insolées à proximité des coins amont de l'image $I_n$ et sont destinées à positionner l'image suivante. Deux autres mires, H et I, sont également insolées, à distance cette fois du bord amont de l'image, le long du bord inférieur de l'image : ces mires H, I sont destinées à positionner l'image verso par rapport à l'image recto en cas d'insolation recto-verso de la bande 410.

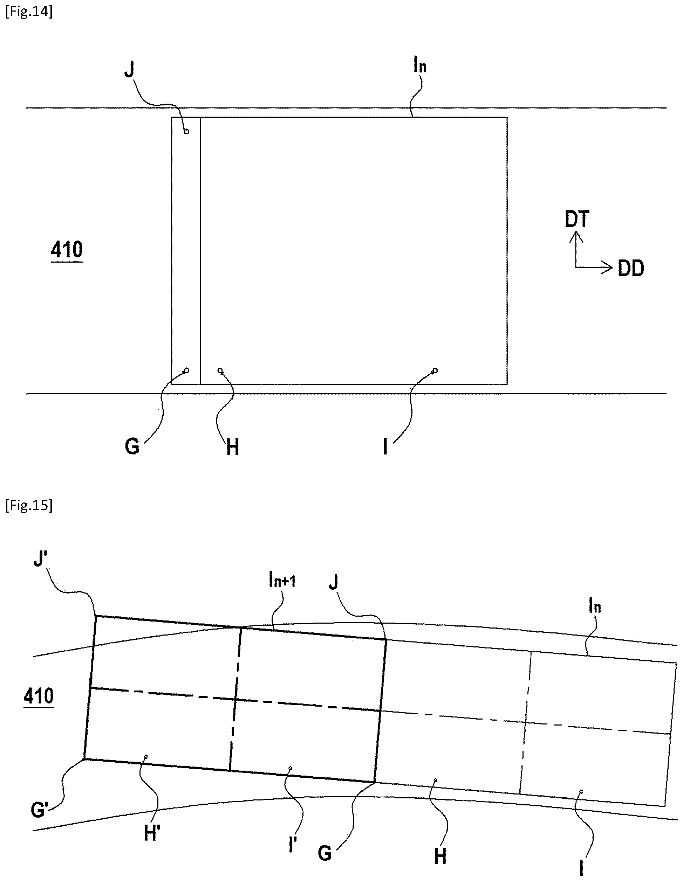

La figure 15 illustre le positionnement de l'image $I_{n+1}$ par rapport à l'image précédente $I_n$. Dans ce cinquième exemple, l'unité numérique de préparation d'image positionne l'image $I_{n+1}$, sans déformation, en positionnant ses points de calage aval sur les mires G et J de l'image $I_n$. Des mires G', H', I' et J' sont également insolées de manière analogue.

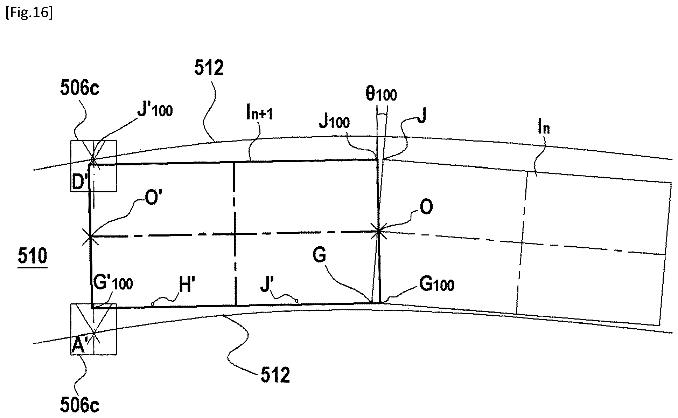

Ainsi, dans ce cinquième exemple, l'image $I_{n+1}$ se positionne dans le prolongement de l'image $I_n$. Dès lors, en fonction de l'importance de la déformation de la bande 410, il se peut que l'image $I_{n+1}$ positionnée de cette manière sorte de la bande 410 comme cela est représenté sur la figure 16. A cet égard, il est toutefois bien entendu rappelé que la déformation de la bande 510 est fortement exagérée sur les figures de telle sorte que de telles sorties de bande restent en pratique limitées en fréquence et en ampleur.

La figure 16 illustre un sixième exemple de méthode de positionnement dans lequel la bande 510 et le positionnement de la première image I1 sont identiques à ceux du cinquième exemple.

Dans ce sixième exemple, le dispositif de vision, dont deux caméras se positionnent à l'emplacement théorique de l'extrémité amont de l'image $I_{n+1}$, détecte le bord 512 de la bande 510 dans le champ 506c de ces deux caméras : il détermine alors les coordonnées des points A' et D' situés, pour chaque caméra, à l'intersection du bord de bande 512 et du segment médian du champ 506c de la caméra.

L'unité numérique de préparation d'image calcule alors, d'une part, la position du centre O du segment GJ et, d'autre part, la position du centre O' du segment A'D'. La droite OO' définit alors l'orientation de l'image $I_{n+1}$.

L'unité numérique de préparation d'image calcule ensuite la position de deux mires virtuelles $G_{100}$, $J_{100}$ en positionnant ces dernières de telle sorte que le segment $G_{100}$, $J_{100}$ soit perpendiculaire à la droite OO', possède O comme centre, et possède une longueur égale à la distance séparant les deux points de calage de l'image $I_{n+1}$. De même, l'unité numérique de préparation d'image calcule la position de deux autre mires virtuelles $G'_{100}$, $J'_{100}$ en positionnant ces dernières de telle sorte que le segment $G'_{100}$, $J'_{100}$ soit perpendiculaire à la droite OO', possède O' comme centre, et possède une longueur égale à la distance séparant les deux points de calage de l'image $I_{n+1}$.

L'image $I_{n+1}$ est alors positionnée, sans déformation, en positionnant ses quatre points de calage sur les quatre points $G'_{100}$, $G_{100}$, $J_{100}$ et $J'_{100}$. Des mires sont également insolées au niveau des points $G'_{100}$ et $J'_{100}$ ; des mires H', J' destiné à l'alignement recto-verso sont également insolées de manière analogue.

Dans ce sixième exemple, on peut noter que, en fonction de l'importance de la déformation de la bande, l'angle $\theta_{100}$ formé entre deux images successives peut être plus ou moins important. En particulier, au-delà d'un certain angle, la longueur de la zone de recouvrement peut être significativement réduite à l'une de ses extrémités, voire un écart peut apparaitre entre les images $I_n$ et $I_{n+1}$.

En conséquence, afin de trouver un compromis entre les avantages et les inconvénients des cinquième et sixième exemples, il est proposé dans un septième exemple de retenir pour l'image $I_{n+1}$ une position intermédiaire entre les positions calculées pour chacun de deux exemples précédents.

Ainsi, dans le septième exemple, l'unité numérique de préparation d'image calcule à la fois les coordonnées des points G, J, G' et J' selon le cinquième exemple et les coordonnées des points $G_{100}$, $J_{100}$, $G'_{100}$ et $J'_{100}$ selon le sixième exemple. L'unité numérique de préparation d'image applique alors un facteur de pondération s à ces deux jeux de coordonnées extrêmes de la manière suivante afin d'obtenir les coordonnées des quatre mires virtuelles à conserver Gv, Jv, G'v et J'v :

$$xGv = xG + (xG_{100}-xG)*s/100$$

$$yGv = yG + (yG_{100}-yG)*s/100$$

$$xJv = xJ + (xJ_{100}-xJ)*s/100$$

$$yJv = yJ + (yJ_{100}-yJ)*s/100$$

$$xG'v = xG' + (xG'_{100}-xG')*s/100$$

$$yG'v = yG' + (yG'_{100}-yG')*s/100$$

$$xJ'v = xJ' + (xJ'_{100}-xJ')*s/100$$

$$yJ'v = yJ' + (yJ'_{100} - yJ')*s/100$$

Ce coefficient de pondération s peut être déterminé de différente manière : prédéterminé en fonction du type d'application visée, sélectionné par l'utilisateur entre plusieurs réglages préenregistrés, saisi manuellement ou encore calculé à partir d'un autre paramètre.

En particulier, ce coefficient de pondération s peut être calculé en fonction de la tolérance de recouvrement souhaitée par l'utilisateur. En connaissant cette tolérance souhaitée t et la largeur des images y, il est en effet possible de calculer l'angle maximal θm toléré entre deux images successives, soit θm = Arctan(t/(y/2)). De là, il est possible de calculer un coefficient s' de la manière suivante : s'=100*θm/θ_{100}. Ce coefficient s' devient alors le coefficient de pondération s s'il est inférieur ou égal 100 ; à défaut, la valeur 100 est retenue pour le coefficient de pondération.

Bien que la présente invention ait été décrite en se référant à des exemples de réalisation spécifiques, il est évident que des modifications et des changements peuvent être effectués sur ces exemples sans sortir de la portée générale de l'invention telle que définie par les revendications. En particulier, des caractéristiques individuelles des différents modes de réalisation illustrés/mentionnés peuvent être combinées dans des modes de réalisation additionnels. Par conséquent, la description et les dessins doivent être considérés dans un sens illustratif plutôt que restrictif.

Il est également évident que toutes les caractéristiques décrites en référence à un procédé sont transposables, seules ou en combinaison, à un dispositif, et inversement, toutes les caractéristiques décrites en référence à un dispositif sont transposables, seules ou en combinaison, à un procédé.

## Revendications

1. Procédé mis en oeuvre par ordinateur pour la préparation d'image pour une machine d'insolation de bande défilante, ladite machine (1) étant configurée pour projeter, à partir d'un ou de plusieurs fichiers numériques (22), une succession d'images (23) les unes à la suite des autres sur une bande (10) défilant dans une direction de défilement (DD) de la machine (1), dans lequel on assure une zone de recouvrement (26) sur la bande insolée (10) entre l'image n+1 ($I_{n+1}$) et l'image n ($I_n$) projetée juste avant **caractérisé en ce que** des mires (24) sont ajoutées à l'image n ($I_n$) à proximité de ses deux angles amont (23a, 23b) et sont utilisées pour positionner l'image n+1 ($I_{n+1}$).

2. Procédé selon la revendication 1, comprenant une étape de découpage d'une image numérique primaire (21) en une pluralité d'images numériques secondaires (23) de longueur plus faible, cette pluralité d'images numériques secondaires (23) formant ladite succession d'images.

3. Procédé selon la revendication 1 ou 2, dans laquelle on ajoute à l'image n+1 ($I_{n+1}$), au-delà de son bord aval originel (23d), un tronçon d'image (23b) issu du bord amont (23a) de l'image n ($I_n$), ou on ajoute à l'image n ($I_n$), au-delà de son bord amont originel, un tronçon d'image issu du bord aval de l'image n+1 ($I_{n+1}$).

4. Procédé selon l'une quelconque des revendications 1 à 3, dans lequel la zone de recouvrement (26) possède, en moyenne sur la largeur de l'interface entre l'image n+1 ($I_{n+1}$) et l'image n ($I_n$), une longueur comprise entre 10 et 200 μm, de préférence entre 50 et 150 μm, de préférence encore entre 80 et 100 μm.

5. Procédé selon l'une quelconque des revendications 1 à 4, dans lequel l'image n+1 ($I_{n+1}$) est positionnée sans déformation en se basant sur au moins deux mires (24) de la bande (10).

6. Procédé selon l'une quelconque des revendications 1 à 4, dans lequel l'image n+1 ($I_{n+1}$) est positionnée, avec éventuelle déformation, de manière à faire coïncider quatre points prédéterminés de l'image avec quatre mires (A', E, F, D') de la bande (210).

7. Procédé selon l'une quelconque des revendications 1 à 6, dans lequel l'image n+1 ($I_{n+1}$) est positionnée en se basant sur deux mires réelles (E, F) insolées avec l'image n ($I_n$) et deux marques réelles (A', D') de la bande (10).

8. Procédé selon l'une quelconque des revendications 1 à 6, dans lequel l'image n+1 ($I_{n+1}$) est positionnée en se basant sur deux mires réelles (E, F) insolées avec l'image n ($I_n$) et deux mires virtuelles ($G'_{100}$ ; $J'_{100}$) issues de la détection des bords (612) de bande (610).

9. Machine d'insolation de bande défilante, comprenant

   un support (2), comportant une zone d'insolation (2a),
   un disposition d'insolation (6), prévu en vis-à-vis de la zone d'insolation (2a) du support (2), comprenant au moins une source lumineuse et au moins un dispositif de projection configuré pour projeter une succession d'images (23) dans la zone d'insolation (2a) à partir d'un ou plusieurs fichiers numériques (22),
   un dispositif de guidage et d'entraînement (4) de bande (10), configuré pour tendre une bande (10) sur le support (2) et pour la déplacer selon une direction de défilement (DD) passant par la zone d'insolation (2a), et

une unité numérique de préparation d'image, configurée pour positionner, orienter, modifier et/ou déformer une image (23) avant sa projection par le dispositif de projection,

dans laquelle l'unité numérique de préparation d'image est configurée pour mettre en œuvre un procédé de préparation d'image selon l'une quelconque des revendications précédentes.

10. Programme d'ordinateur comprenant des instructions pour exécuter les étapes du procédé de préparation d'image de l'une quelconque des revendications 1 à 8.

**Patentansprüche**

1. Verfahren, durchgeführt von einem Computer, für die Bildvorbereitung für eine Bandbelichtungsmaschine, wobei die Maschine (1) konfiguriert ist, um anhand einer oder mehrerer digitaler Dateien (22) eine Abfolge von Bildern (23) nacheinander auf ein Band (10) zu projizieren, das in einer Laufrichtung (DD) der Maschine (1) läuft, wobei ein Überlappungsbereich (26) auf dem belichteten Band (10) zwischen dem Bild n+1 ($I_{n+1}$) und dem unmittelbar davor projizierten Bild n ($I_n$) gewährleistet wird, **dadurch gekennzeichnet, dass** dem Bild n ($I_n$) in der Nähe seiner zwei stromaufwärtigen Ecken (23a, 23b) Positionsmarkierungen (24) hinzugefügt werden, die zum Positionieren des Bilds n+1 ($I_{n+1}$) verwendet werden.

2. Verfahren nach Anspruch 1, umfassend einen Schritt eines Zerschneidens eines primären digitalen Bilds (21) in eine Vielzahl von sekundären digitalen Bildern (23) geringerer Länge, wobei diese Vielzahl von sekundären digitalen Bildern (23) die Abfolge von Bildern bildet.

3. Verfahren nach Anspruch 1 oder 2, wobei dem Bild n+1 ($I_{n+1}$) über seinen ursprünglichen stromabwärtigen Rand (23d) hinaus einen Bildabschnitt (23b) hinzugefügt wird, der von dem stromaufwärtigen Rand (23a) des Bilds n ($I_n$) stammt, oder dem Bild n ($I_n$) über seinen ursprünglichen stromaufwärtigen Rand hinaus einen Bildabschnitt hinzugefügt wird, der von dem stromabwärtigen Rand des Bilds n+1 ($I_{n+1}$) stammt.

4. Verfahren nach einem der Ansprüche 1 bis 3, wobei der Überlappungsbereich (26) im Durchschnitt über die Breite der Grenzfläche zwischen dem Bild n+1 ($I_{n+1}$) und dem Bild n ($I_n$) eine Länge zwischen 10 und 200 $\mu$m, vorzugsweise zwischen 50 und 150 $\mu$m, bevorzugter zwischen 80 und 100 $\mu$m, besitzt.

5. Verfahren nach einem der Ansprüche 1 bis 4, wobei das Bild n+1 ($I_{n+1}$) verzerrungsfrei basierend auf mindestens zwei Testmustern (24) des Bands (10) positioniert wird.

6. Verfahren nach einem der Ansprüche 1 bis 4, wobei das Bild n+1 ($I_{n+1}$) unter eventueller Verzerrung positioniert wird, um vier vorbestimmte Punkte des Bilds mit vier Positionsmarkierungen (A', E, F, D') des Bands (210) in Übereinstimmung zu bringen.

7. Verfahren nach einem der Ansprüche 1 bis 6, wobei das Bild n+1 ($I_{n+1}$) basierend auf zwei realen Positionsmarkierungen (E, F), die mit dem Bild n ($I_n$) belichtet sind, und zwei realen Positionsmarkierungen (A', D') des Bands (10) positioniert wird.

8. Verfahren nach einem der Ansprüche 1 bis 6, wobei das Bild n+1 ($I_{n+1}$) basierend auf zwei realen Positionsmarkierungen (E, F), die mit dem Bild n ($I_n$) belichtet sind, und zwei virtuellen Positionsmarkierungen ($G'_{100}$; $J'_{100}$), die aus der Randerfassung (612) des Bands (610) stammen, positioniert wird.

9. Bandbelichtungsmaschine, umfassend einen Träger (2), der einen Belichtungsbereich (2a) aufweist,

eine Belichtungsanordnung (6), die gegenüber dem Belichtungsbereich (2a) des Trägers (2) bereitgestellt ist, umfassend mindestens eine Lichtquelle und mindestens eine Projektionsvorrichtung, die konfiguriert ist, um anhand einer oder mehrerer digitaler Dateien (22) eine Abfolge von Bildern (23) in den Belichtungsbereich (2a) zu projizieren,

eine Führungs- und Antriebsvorrichtung (4) für ein Band (10), die konfiguriert ist, um ein Band (10) auf dem Träger (2) zu spannen und es in einer Laufrichtung (DD) zu bewegen, die durch den Belichtungsbereich (2a) verläuft, und

eine digitale Bildvorbereitungseinheit, die konfiguriert ist, um ein Bild (23) vor seiner Projektion durch die Projektionsvorrichtung zu positionieren, auszurichten, zu modifizieren und/oder zu verzerren,

wobei die digitale Bildvorbereitungseinheit konfiguriert ist, um ein Bildvorbereitungsverfahren nach einem der vorherigen Ansprüche durchzuführen.

10. Computerprogramm, umfassend Anweisungen zum Ausführen der Schritte des Bildvorbereitungsverfahrens nach einem der Ansprüche 1 bis 8.

**Claims**

1. A computer-implemented method for preparing an image for a moving web exposure machine, said machine (1) being configured to project, from one or more digital files (22), a succession of images (23) following one another on a web (10) traveling in a travel direction (DD) of the machine (1), wherein an overlapping zone (26) is provided on the exposed web (10) between the image n +1 ($I_{n+1}$) and the image n ($I_n$) projected just before, **characterized in that** fiducial marks (24) are added to the image n ($I_n$) close to its two upstream corners (23a, 23b) and are used to position the image n+1 ($I_{n+1}$).

2. The method according to claim 1, comprising a step of dividing a primary digital image (21) into a plurality of secondary digital images (23) of shorter length, this plurality of secondary digital images (23) forming said succession of images.

3. The method according to claim 1 or 2, wherein an image segment (23b) from the upstream edge (23a) of the image n ($I_n$) is added to the image n+1 ($I_{n+1}$), beyond its original downstream edge (23d), or an image segment from the downstream edge of the image n+1 ($I_{n+1}$) is added to the image n ($I_n$), beyond its original upstream edge.

4. The method according to any one of claims 1 to 3, wherein the overlapping zone (26) has, on average over the width of the interface between the image n+1 ($I_{n+1}$) and the image n ($I_n$), a length of between 10 and 200 $\mu$m, preferably between 50 and 150 $\mu$m, more preferably between 80 and 100 $\mu$m.

5. The method according to any one of claims 1 to 4, wherein the image n+1 ($I_{n+1}$) is positioned without deformation based on at least two fiducial marks (24) of the web (10).

6. The method according to any one of claims 1 to 4, wherein the image n+1 ($I_{n+1}$) is positioned, with any deformation, so as to cause four predetermined points of the image to coincide with four patterns (A', E, F, D') of the web (210).

7. The method according to any one of claims 1 to 6, wherein the image n+1 ($I_{n+1}$) is positioned based on two real fiducial marks (E, F) exposed with the image n ($I_n$) and two real marks (A', D') of the web (10).

8. The method according to any one of claims 1 to 6, wherein the image n+1 ($I_{n+1}$) is positioned based on two real fiducial marks (E, F) exposed with the image n ($I_n$) and two virtual fiducial marks ($G'_{100}$; $J'_{100}$) resulting from the detection of the edges (612) of the web (610).

9. A moving web exposure machine, comprising a support (2), comprising an exposure area (2a),

an exposure system (6) arranged opposite the exposure area (2a) of the support (2), comprising at least one light source and at least one projection device configured to project a succession of images (23) onto the exposure area (2a) from one or more digital files (22),
a web (10) guiding and driving device (4), configured to tension a web (10) on the support (2) and move it along a travel direction (DD) passing through the exposure area (2a), and
a digital image preparation unit, configured to position, orient, modify and/or distort an image (23) before its projection by the projection device,
wherein the digital image preparation unit is configured to implement an image preparation method according to any one of the preceding claims.

10. A computer program comprising instructions for carrying out the steps of the image preparation method of any one of claims 1 to 8.

EP 4 053 635 B1

[Fig.1]

[Fig.2]

[Fig.3]

[Fig.4]

[Fig.5]

[Fig.6]

[Fig.7]

[Fig.8]

[Fig.9]

[Fig.10]

[Fig.11A]

[Fig.11B]

[Fig.11C]

[Fig.12]

[Fig.13]

[Fig.14]

[Fig.15]

[Fig.16]

# EP 4 053 635 B1

## RÉFÉRENCES CITÉES DANS LA DESCRIPTION

**Documents brevets cités dans la description**

- US 2008094465 A
- US 2006132735 A
- WO 2011096428 A
- JP 2000227661 A